(19) Europäisches Patentamt

European Patent Office

Office européen des brevets

(11) **EP 4 582 815 A1**

(12) **EUROPEAN PATENT APPLICATION**

(43) Date of publication:
**09.07.2025 Bulletin 2025/28**

(21) Application number: **24223175.1**

(22) Date of filing: **24.12.2024**

(51) International Patent Classification (IPC):
*G01P 15/125* (2006.01)    *G01P 15/08* (2006.01)

(52) Cooperative Patent Classification (CPC):
**G01P 15/125;** G01P 2015/0831; G01P 2015/0871;
G01P 2015/0882

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.01.2024 IT 202400000153**

(71) Applicant: **STMicroelectronics International N.V.**
**1228 Plan-les-Ouates, Geneva (CH)**

(72) Inventors:
• **RIZZINI, Francesco**
  **25050 Passirano (BS) (IT)**
• **DALL'OGLIO, Cristian**
  **93015 Niscemi (CL) (IT)**
• **LUBERTO, Alessandro**
  **20141 Milano (IT)**
• **MANCA, Nicolo'**
  **10154 Torino (IT)**
• **FOLETTO, Laura**
  **22060 Novedrate (CO) (IT)**

(74) Representative: **Studio Torta S.p.A.**
**Via Viotti, 9**
**10121 Torino (IT)**

(54) **MEMS ACCELEROMETER HAVING A HIGH MECHANICAL ROBUSTNESS**

(57)    A MEMS accelerometer (10) has a substrate (11) and a sensing mass (12) suspended at a distance from the substrate along an out-of-plane direction (Z). The sensing mass is coupled to the substrate so as to undergo an out-of-plane movement with respect to the substrate, in response to an acceleration along the out-of-plane direction. The MEMS accelerometer also has a damping structure (25A-25D) configured to damp an in-plane movement of the sensing mass with respect to the substrate. The damping structure has a plurality of movable fingers (30A-30D) integral with the sensing mass (12) and a plurality of fixed fingers (31A-31E) integral with the substrate (11) and interdigitated with the movable fingers. The movable fingers and/or the fixed fingers have, along a first in-plane direction (X) transversal to the out-of-plane direction (Z), a variable length.

FIG. 1

## Description

Technical Field

The present invention relates to a MEMS ("Micro ElectroMechanical Systems") accelerometer having a high mechanical robustness. In particular, the invention refers to an out-of-plane MEMS accelerometer and, even more in particular, to a MEMS accelerometer for high accelerations (high-g MEMS accelerometer).

Background

As known, MEMS accelerometers are widely spread owing to their small dimensions and high detection sensitivity.

Common applications of the MEMS accelerometers include shock monitoring, for example to detect car accidents or possible falls to ground of a person; detection of gestures by a user, such as a rotation of a smartphone screen or a specific type of user touch; and the use as bone conductivity detectors, for example as a microphone in True Wireless Stereo (TWS) earphones.

Currently, low-G accelerometers are known adapted for detecting low accelerations, for example having a Full Scale Range (FSR) equal to 16 g or 32 g, and high-G sensors for detecting high accelerations, for example having a full-scale range equal to 128 g, wherein $g = 9.81 \text{ m/s}^2$.

High-g MEMS accelerometers need to withstand greater stresses than low-g accelerometers and may generally have lower sensitivity.

The Applicant has verified that known MEMS accelerometers, in particular those for high accelerations, may suffer from mechanical robustness and detection accuracy or sensitivity that are not sufficient for specific applications.

For example, high-g MEMS accelerometers are known which have a high resonance frequency in order to ensure the required full scale.

At the same time, these MEMS accelerometers are configured so as to have an overdamped frequency response, and therefore a low quality factor Q. This allows for high immunity to vibrations to be ensured, both along the sensing direction and along directions orthogonal to that of sensing.

One approach to reduce the quality factor Q is to use in-plane mechanical damping structures. However, to ensure their effectiveness, the known mechanical damping structures require a high area; however, this may compromise the mechanical robustness of the MEMS accelerometer.

Out-of-plane MEMS accelerometers are also known wherein, in response to a high in-plane acceleration, the sensing mass is subject to a high in-plane rotation. The high in-plane rotation of the sensing mass may cause mechanical breakage of the sensing mass and therefore malfunctions of the MEMS accelerometer.

US 2023/314466 A1 discloses an inertial sensor including a movable body and an attenuator that attenuates a displacement of the movable body with respect to the substrate. The attenuator includes a comb-shaped first structure including a plurality of movable comb fingers whose base ends are coupled to the movable body, and a comb-shaped second structure including a plurality of fixed comb fingers whose base ends are coupled to the substrate, intersecting with each other. The movable comb fingers are spaced apart one from the other along a first axis, the fixed comb fingers are spaced apart one from the other along the first axis, and a width (measured along the first axis) of the base end of each of the movable comb fingers and the fixed comb fingers is larger than a width (measured along the first axis) of a tip end thereof.

The aim of the present invention is to overcome, at least in part, the disadvantages of the prior art.

Summary

According to the present invention, a MEMS accelerometer is therefore provided, as defined in the attached claims.

Brief Description of the Drawings

For a better understanding of the present invention, embodiments thereof are now described, purely by way of nonlimiting example, with reference to the attached drawings, wherein:

- Figure 1 shows a top-plan view of an out-of-plane MEMS accelerometer, according to one embodiment;
- Figure 2 shows a schematic cross-section of the accelerometer of Figure 1, along a section line II-II of Figure 1;
- Figure 3A shows a top-plan view of an enlarged portion of the MEMS accelerometer of Figure 1;
- Figure 3B shows in detail a part of the enlarged portion of Figure 3A;
- Figure 4 shows a top-plan view of another enlarged portion of the MEMS accelerometer of Figure 1;
- Figure 5 shows the MEMS accelerometer of Figure 1, in use, in presence of an external in-plane shock;
- Figures 6A and 6B show cross-sections of portions of the MEMS accelerometer of Figure 1;
- Figure 7 shows a schematic top-plan view of the MEMS accelerometer of Figure 1, comprising a cap;
- Figure 8 shows a cross-section of the MEMS accelerometer of Figure 7, along a section line VIII-VIII;
- Figure 9 shows a schematic top representation of the cap in Figure 7;
- Figure 10 shows a schematic top-plan view of the layout of an inertial device comprising a plurality of inertial sensors; and
- Figure 11 shows a perspective view of the inertial device of Figure 10, mounted on a support.

Description of Embodiments

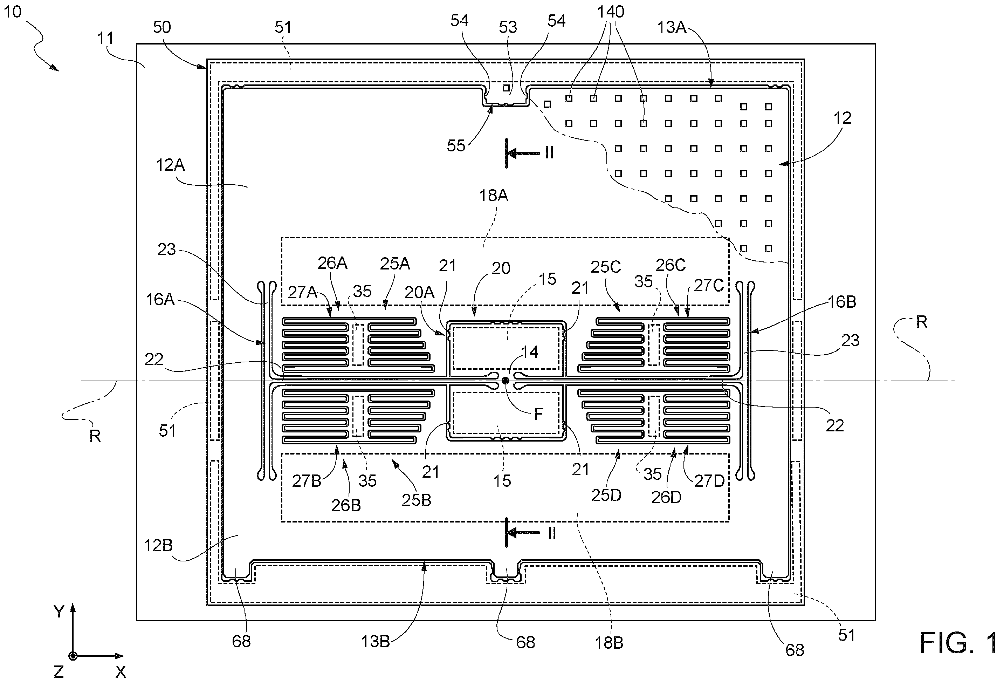

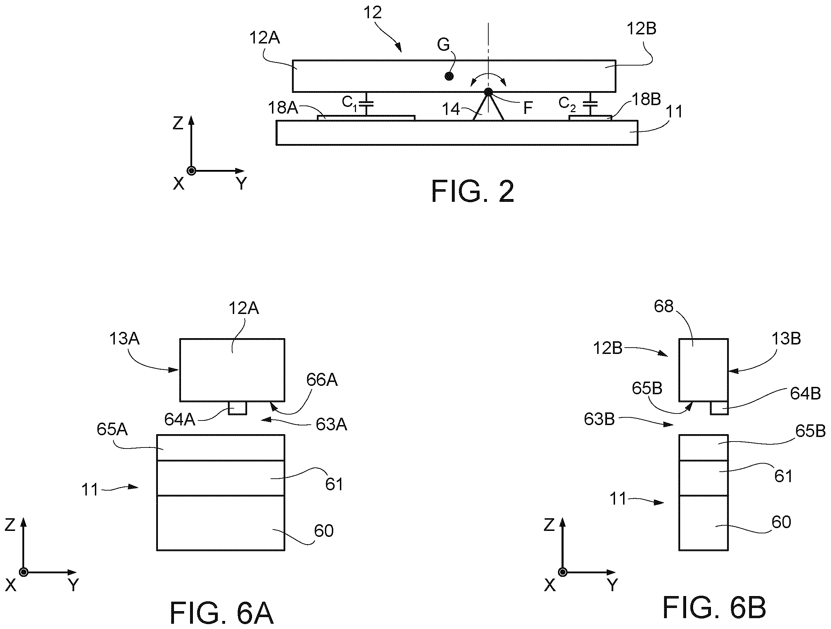

Figures 1 and 2 show a MEMS accelerometer 10 in a Cartesian reference system XYZ having a first axis X, a second axis Y and a third axis Z.

The MEMS accelerometer 10 is formed through micromachining techniques starting from a body of semiconductor material, such as silicon.

The MEMS accelerometer 10 is an out-of-plane MEMS accelerometer, configured to detect an acceleration along an out-of-plane direction, i.e. here along the third axis Z. In particular, the MEMS accelerometer 10 may be a high-g accelerometer, i.e. configured to have a full-scale range greater than 32g, in particular greater than 100g, more in particular greater than 128g and even more in particular comprised between 260g and 700g, wherein g is the earth gravity acceleration equal to 9.81 $m/s^2$.

The full-scale range may be defined as the maximum acceleration value (in absolute value) detectable by the MEMS accelerometer. For example, an accelerometer having a full scale of 100g may be able to detect accelerations comprised between -100g and +100g, that is accelerations having maximum amplitudes equal to -100g and +100g.

The MEMS accelerometer 10 comprises a substrate 11 and a sensing mass 12 suspended on the substrate 11. The sensing mass 12 extends at a distance from the substrate 11 along the third axis Z.

The sensing mass 12 is coupled to the substrate 11 so as to undergo an out-of-plane movement (that is having a component along the third axis Z) with respect to the substrate 11, in response to an external acceleration of the MEMS accelerometer 10 along the third axis Z.

In detail, the sensing mass 12 is substantially planar with main extension in a plane XY formed by the first and the second axes X, Y.

The MEMS accelerometer 10 comprises a central anchoring region 14 fixed to the substrate 11 through respective pillars 15 (indicated by a dashed line in Figure 1), and springs 16A, 16B which extend between the central anchoring region 14 and the sensing mass 12. The springs 16A, 16B maintain, at rest, the sensing mass 12 suspended on the substrate 11.

The springs 16A, 16B allow the out-of-plane movement of the sensing mass 12, in response to an acceleration along the third axis Z undergone by the MEMS accelerometer 10.

The MEMS accelerometer 10 comprises sensing electrodes 18A, 18B fixed to the substrate 11 and arranged at a distance, along the third axis Z, from the sensing mass 12.

The sensing electrodes 18A, 18B are capacitively coupled to the sensing mass 12, forming respective capacitors $C_1$, $C_2$ therewith.

In this embodiment, the MEMS accelerometer 10 has a teeter-totter structure, as shown in the schematic cross-section of Figure 2.

The sensing mass 12 has a barycenter G.

The springs 16A, 16B couple the sensing mass 12 to the central anchoring region 14 at a fulcrum point F having an offset with respect to the barycenter G of the sensing mass 12.

The springs 16A, 16B are torsional elastic elements configured to allow a rotation of the sensing mass 12 around a rotation axis R passing through the fulcrum point F.

The rotation axis R is transversal, in particular perpendicular, to the third axis Z.

The rotation axis R is a non-barycentric axis, i.e. it does not pass through the barycenter G of the sensing mass 12.

In the arrangement of Figure 1, the rotation axis R is parallel to the first axis X.

In detail, the sensing mass 12 has a major portion 12A extending on a first side of the rotation axis R along the second axis Y, and a minor portion 12B extending on a second side of the rotation axis R opposite to the first side along the second axis Y.

The major portion 12A and the minor portion 12B form an external (perimeter) wall 13A and, respectively, 13B of the sensing mass 12.

The major portion 12A has a greater mass than the minor portion 12B.

In particular, the major portion 12A has greater dimensions than the minor portion 12B.

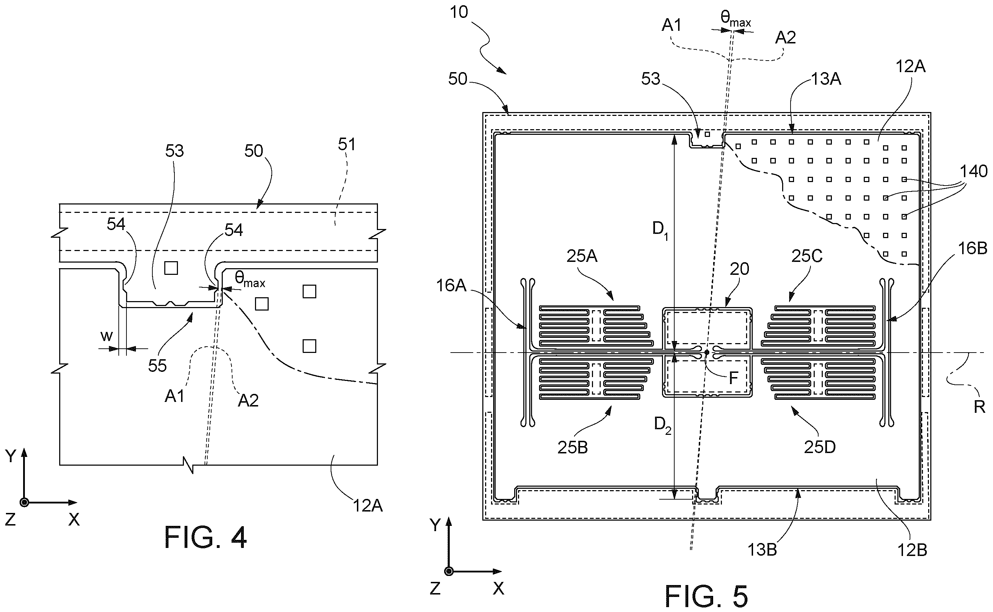

In detail, as shown in Figure 5, in this embodiment, the external wall 13A extends, along the second axis Y, at a distance $D_1$ from the rotation axis R and the external wall 13B extends, along the second axis Y, at a distance $D_2$ from the rotation axis R which is shorter than the distance $D_1$.

Accordingly, the barycenter G of the sensing mass 12 is arranged on the first side of the rotation axis R, in particular here inside the major portion 12A of the sensing mass 12.

The major portion 12A faces the sensing electrode 18A. The minor portion 12B faces the sensing electrode 18B.

In the embodiment of Figure 1, a through cavity 20 extends, along the third axis Z, through the sensing mass 12. In detail, the sensing mass 12 has an internal wall 20A which faces the through cavity 20 and the central anchoring region 14.

The central anchoring region 14, the pillars 15 and the springs 16A, 16B extend inside the through cavity 20. This may allow the area occupation of the MEMS accelerometer 10 to be optimized.

The central anchoring region 14 may comprise protruding portions 21 which extend, along the first axis X, towards the internal wall 20A of the sensing mass 12. The protruding portions 21 extend, at rest, at a distance along the first axis X from the internal wall 20A; for example, at a distance comprised between 1.4 $\mu$m and 1.6 $\mu$m. The protruding portions 21 are stopper regions of the sensing mass 12 along the first axis X.

In this embodiment, the springs 16A, 16B have a T-shape. In detail, the torsional springs 16A, 16B each have a respective longitudinal portion 22, which extends parallel to the first axis X from the central anchoring region 14, and a respective transversal portion 23 which extends transversally to the respective longitudinal portion 22.

In particular, the longitudinal portions 22 extend along the rotation axis R.

In particular, the transversal portions 23 extend parallel to the second axis Y.

In particular, here, the transversal portion 23 of the springs 16A, 16B is coupled to one end of the respective longitudinal portion 22.

The sensing mass 12 is coupled to the transversal portions 23 of the springs 16A, 16B, in particular to the ends of the respective transversal portions 23.

The MEMS accelerometer 10 further comprises one or more damping structures configured to damp in-plane movements (along the first and/or the second axes X, Y) of the sensing mass 12.

In particular, in the embodiment of Figure 1, the MEMS accelerometer 10 comprises four modified damping structures 25A, 25B, 25C, 25D and four additional damping structures 26A, 26B, 26C 26D.

The modified damping structures 25A, 25C and the additional damping structures 26A, 26C are damping structures of the major portion 12A of the sensing mass 12. The modified damping structures 25B, 25D and the additional damping structures 26B, 26D are damping structures of the minor portion 12B of the sensing mass 12.

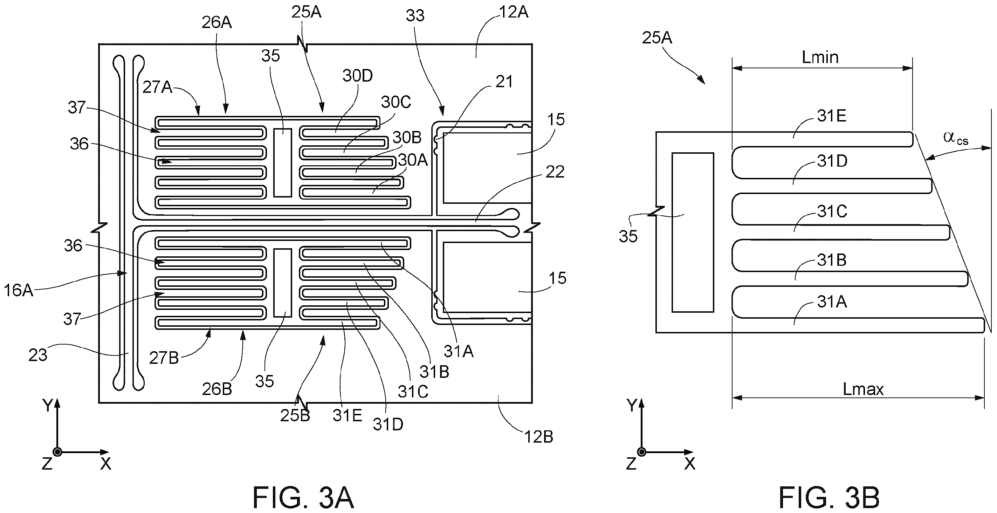

As shown in detail in Figures 3A and 3B for the modified damping structures 25A, 25B, the modified damping structures 25A-25D each comprise a respective plurality of movable fingers (or protrusions), here four movable fingers 30A-30D, integral with the sensing mass 12, and a respective plurality of fixed fingers (or protrusions) 31, here five fixed fingers 31A-31E, integral with the substrate 11.

For each modified damping structure 25A-25D, the movable fingers 30A-30D are interdigitated with the respective fixed fingers 31A-31E.

In this embodiment, the modified damping structures 25A-25D are each arranged inside a respective through cavity 27A-27D of the sensing mass 12; this may allow the die area occupation of the MEMS accelerometer 10 to be minimized.

In this embodiment, the through cavities 27A-27D extend, in the plane XY, at a distance from the through cavity 20.

The through cavity 27A extends, in the major portion 12A of the sensing mass 12, to the side of the rotation axis R, in particular to the side of the longitudinal portion 22 of the spring 16A along the second axis Y.

The through cavity 27C extends, in the major portion 12A of the sensing mass 12, to the side of the rotation axis R, in particular to the side of the longitudinal portion 22 of the spring 16B along the second axis Y.

The through cavity 27B extends, in the minor portion 12B of the sensing mass 12, to the side of the rotation axis R, in particular to the side of the longitudinal portion 22 of the spring 16A along the second axis Y.

The through cavity 27D extends, in the minor portion 12B of the sensing mass 12, to the side of the rotation axis R, in particular to the side of the longitudinal portion 22 of the spring 16B along the second axis Y.

The through cavities 27A, 27C extend, along the first axis X, on two opposite sides of the central anchoring region 14, inside the major portion 12A of the sensing mass 12. The through cavities 27B, 27D extend, along the first axis X, on two opposite sides of the central anchoring region 14, inside the minor portion 12B of the sensing mass 12.

In detail, the modified damping structures 25A-25D each comprise a respective anchoring region 35 fixed to the substrate 11. The fixed fingers 31A-31E extend from the respective anchoring region 35 at a distance from each other.

In this embodiment, the fixed fingers 31A-31E extend towards the internal wall 20A; in particular, parallel to the first axis X and at a distance from each other along the second axis Y.

The movable fingers 30A-30D extend, at a distance from each other, between the fixed fingers 31A-31E, facing each other.

In particular, the movable fingers 30A-30D extend parallel to the first axis X towards the respective anchoring region 35, at a distance from each other along the second axis Y. In this embodiment, the movable fingers 30A-30D each extend, along the second axis Y, between two adjacent fingers of the fixed fingers 31A-31E.

For each modified damping structure 25A-25D, the movable finger 30A is arranged, along the second axis Y, at a shorter distance from the rotation axis R with respect to the movable finger 30D. Similarly, the fixed finger 31A is arranged, along the second axis Y, at a shorter distance from the rotation axis R with respect to the fixed finger 31E.

Furthermore, as shown in detail in Figure 3A, the movable finger 30D and the fixed finger 31E face, along the first axis X, a curvature portion 33 of the internal wall 20A.

The movable fingers 30A-30D and the fixed fingers 31A-31E have a variable length along the first axis X.

In detail, the movable fingers 30A-30D and the fixed fingers 31A-31E have a length measured along the first axis X which is decreasing moving away from the rotation axis R along the second axis Y. This may allow to optimize the trade-off between damping effectiveness and area occupation of the damping structures 25A-25D and, at the same time, to guarantee a high mechanical robustness of the MEMS accelerometer 10.

In other words, with reference for simplicity to the fixed fingers 31A-31E of the modified damping structure 25A shown in Figure 3B, the fixed finger 31A has a maximum length Lmax and the fixed finger 31E has a minimum length Lmin.

The maximum length Lmax may be comprised, for example, between 40 $\mu$m and 50 $\mu$m.

The minimum length Lmin may be comprised, for example, between 25 $\mu$m and 40 $\mu$m.

In particular, in this embodiment, the fixed fingers 31A-31E follow a linear length-reduction trend; this may allow to maximize the trade-off between damping effectiveness, area occupation and mechanical robustness. For example, with reference to Figure 3B, the ends of the fixed fingers 31A-31E form an angle $\alpha_{cs}$ with an axis parallel to the second axis Y.

The angle $\alpha_{cs}$ may be comprised, for example, between 20° and 45°; this may allow to optimize the trade-off between damping effectiveness, area occupation and mechanical robustness.

It will be clear to the person skilled in the art that the geometric considerations discussed in reference to the fixed fingers 31A-31E of Figure 3B also apply to the movable fingers 30A-30D interdigitated therewith.

The additional damping structures 26A-26D also extend inside the through cavities 27A-27D, one for each through cavity 27A-27D. In practice, the modified damping structures 25A-25D each share the respective through cavity 27A-27D with a respective additional damping structure 26A-26D.

The additional damping structures 26A-26D each comprise respective movable fingers 37 and respective fixed fingers 36 interdigitated with each other.

The fixed fingers 36 of the additional damping structures 26A-26D extend from the anchoring region 35 of the respective modified damping structure 25A-25D in the opposite direction with respect to the fixed fingers 31A-31E, i.e. towards the transversal portion 23 of the respective spring 16A, 16B.

In the embodiment shown, the fixed fingers 36 and the movable fingers 37 have constant length along the first axis X. This may allow the damping effectiveness to be maximized.

The Applicant has verified that the presence of in-plane damping structures having interdigitated fingers of variable length allows the trade-off between damping effectiveness, area occupation and mechanical robustness to be optimized.

The variable length may be particularly useful for optimizing the performance of the MEMS accelerometer 10 in case the MEMS accelerometer 10 is a high-g out-of-plane accelerometer.

In particular, the length of the interdigitated fingers 30A-30D and 31A-31E may be adjusted, during the design step, so as to ensure a high mechanical robustness in the regions of the sensing mass 12 that are subject, in use, to high mechanical stress.

For example, with reference to the embodiment described and shown, the Applicant has verified that, in presence of a high in-plane acceleration (shock), for example along the first axis X, the sensing mass 12 is subject, at the curvature portion 33 of the internal wall 20A, to a high mechanical stress.

The fact that the length of the fingers 30D, 31E, arranged at the curvature portion 33, is the minimum length of the respective group of fingers, allows the mechanical robustness of the sensing mass 12 to be increased at the curvature portion 33.

Consequently, the MEMS accelerometer 10 may have a reduced risk of breakage in presence of high external accelerations.

In other words, the presence of damping structures having fingers of variable length contribute to optimizing performance and reliability of the MEMS accelerometer 10.

Again with reference to Figure 1, the MEMS accelerometer 10 comprises a frame 50 which is fixed to the substrate 11 through respective pillars 51 (indicated by dashed lines in Figure 1), and which extends around the sensing mass 12, at a distance from the sensing mass 12.

The pillars 51 may have a minimum width, along the first or the second axes X, Y, comprised for example between 4 $\mu$m and 15 $\mu$m. In particular, the width of the pillars 51 may have smaller values when other sensors, for example other accelerometers and/or gyroscopes, are formed on the substrate 11.

The frame 50 comprises a bumper region 53, shown in detail in the enlarged portion of Figure 4, which extends along the second axis Y towards the sensing mass 12 inside a recess 55 of the sensing mass 12.

The bumper region 53 may be optional.

In the embodiment of Figure 1, the recess 55 is formed on the external wall 13A of the major portion 12A of the sensing mass 12.

The bumper region 53 extends, at rest (i.e. in the absence of accelerations), at a distance from the sensing mass 12.

The bumper region 53 comprises a plurality of protruding portions 54 which extend from the bumper region 53, along the first axis X, towards the sensing mass 12.

The protruding portions 54 extend, at rest, at a distance w from the sensing mass 12 along the first axis X; for example, the distance w may be comprised between 1.4 $\mu$m and 2 $\mu$m.

In use, in the presence of an in-plane acceleration, for example along the first or the second axes X, Y, the sensing mass 12 may be subject to an in-plane rotation (i.e., in the plane XY) around the fulcrum point F.

The bumper region 53, with the respective protruding portions 54, acts as an in-plane stopper region of the sensing mass 12. In practice, as shown in Figure 5, the bumper region 53 defines the maximum in-plane rotation angle $\theta_{max}$ to which the sensing mass 12 may be subject. The angle $\theta_{max}$ is defined as the angle between a first line A1 and a second line A2 (also shown in the enlarged detail of Figure 4), wherein the line A1 is the line that passes between the end of a protruding portion 54 and the fulcrum point F, and wherein the line A2 is the line that passes between the fulcrum point F and the portion of the sensing mass 12 facing the protruding portion 54 along the first axis X.

Furthermore, the external wall 13A is at a long distance with respect to the fulcrum point F along the second axis Y, in particular longer than the distance from the fulcrum point F of the external wall 13B and the internal wall 20A.

As a result, the fact that the bumper region 53 is formed with the external wall 13A allows to minimize the maximum in-plane rotation angle $\theta_{max}$ to which the sensing mass 12 may be subject, thereby reducing the risk of mechanical breakage of the MEMS accelerometer 10.

In other words, the bumper region 53 may contribute to further optimizing the performance and reliability of the MEMS accelerometer 10.

Figure 6A shows a cross-section of a portion of the MEMS accelerometer 10 at the external wall 13A of the major portion 12A of the sensing mass 12. Figure 6B shows a cross-section of a portion of the MEMS accelerometer 10 at the external wall 13B of the minor portion 12B of the sensing mass 12.

As visible in the detail of Figures 6A and 6B, the substrate 11 may comprise a bulk region 60 of semiconductor material (for example, silicon) and an insulating region 61 (for example, of silicon oxide) overlying the bulk region 60.

The MEMS accelerometer 10 further comprises out-of-plane lower stopper regions 63A, 63B of the sensing mass 12.

The out-of-plane lower stopper region 63A comprises a first protruding portion 64A, integral with the major portion 12A of the sensing mass 12, and a second protruding portion 65A, integral with the substrate 11 and facing the first protruding portion 64A along the third axis Z.

In detail, the first protruding portion 64A extends from a lower surface 66A of the major portion 12A of the sensing mass 12, along the third axis Z, towards the substrate 11.

The first protruding portion 64A is arranged, along the second axis Y, in proximity to the external wall 13A, for example at a short distance from the external wall 13A, for example about 70 $\mu$m.

In general, the first protruding portion 64A may be arranged at a distance from the external wall 13A, along the second axis Y, so as to ensure contact with the second protruding portion 65A before the portion of the sensing mass 12 at the external wall 13A touches with the underlying second protruding portion 65A.

The out-of-plane lower stopper region 63B comprises a first protruding portion 64B, integral with the minor portion 12B of the sensing mass 12, and a second protruding portion 65B, integral with the substrate 11 and facing the first protruding portion 64B along the third axis Z.

In detail, in the embodiment shown, the sensing mass 12 comprises peripheral portions 68 which extend from the minor portion 12B, along the second axis Y, towards the outside of the minor portion 12B. In practice, the peripheral portions 68 form protruding portions of the external wall 13B.

The first protruding portion 64B extends from a lower surface 66B of the peripheral portion 68 of the sensing mass 12, along the third axis Z, towards the substrate 11.

The first protruding portion 64B is arranged at the external wall 13B.

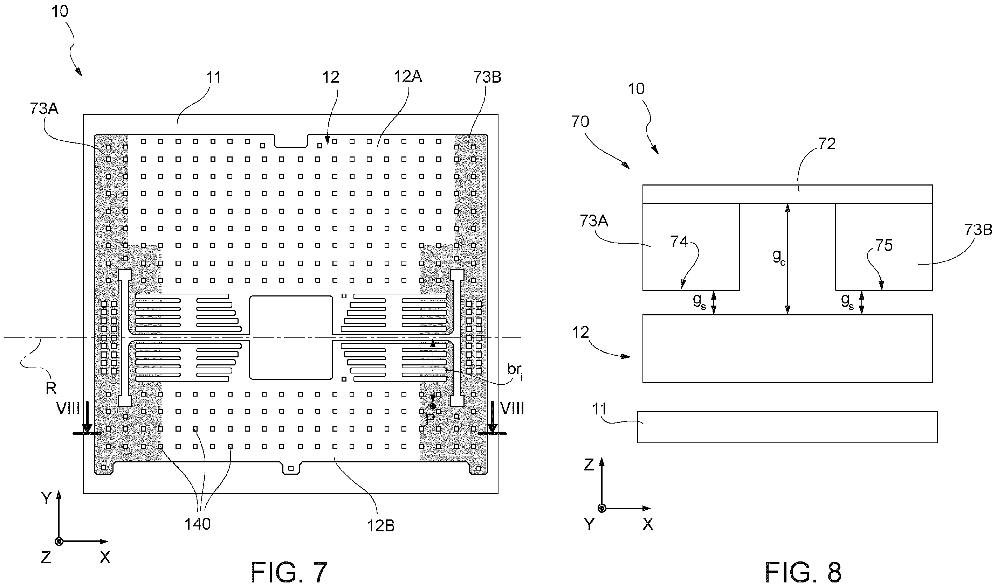

As shown in Figures 7 and 8, the MEMS accelerometer 10 may comprise a cap 70, formed for example starting from a wafer of semiconductor material, in particular silicon, fixed to the substrate 11 in a manner not shown here. The cap 70 may be bonded to the substrate 11 through a bonding region of insulating material, for example glass frit.

The cap 70 and the substrate 11 may form a hermetic chamber, not shown here, accommodating the sensing mass 12.

The cap 70 comprises an upper region 72 and two protruding regions 73A, 73B which extend along the third axis Z over the sensing mass 12, on the opposite side with respect to the substrate 11 (indicated for clarity by gray colored regions in Figure 7).

For simplicity, in Figure 7, only the protruding regions 73A, 73B of the cap 70 are shown in transparency as gray-colored areas.

The upper region 72 extends at a distance $g_c$, comprised for example between 30 $\mu$m and 80 pm, along the third axis Z from the sensing mass 12.

The protruding region 73A has a lower surface 74 facing the sensing mass 12. The lower surface 74 extends, at rest, at a distance $g_s$ along the third axis Z which is shorter than the distance $g_c$. For example, the distance $g_s$ may be comprised between 4 $\mu$m and 10 $\mu$m.

The protruding region 73B has a lower surface 75 facing the sensing mass 12. The lower surface 75 extends, at rest, to the distance $g_s$ along the third axis Z. However, the lower surface 75 may extend to a different distance from the sensing mass 12 with respect to the lower surface 74.

In practice, the protruding regions 73A, 73B are out-of-plane upper stopper regions of the sensing mass 12.

The protruding regions 73A, 73B and the upper region 72 are sized so that, in use, in the presence of an electric potential difference between the cap 70 and the sensing mass 12, the overall torque $M_{tot}$ exerted by the cap 70 on the sensing mass 12 with respect to the rotation axis R is zero.

For example, the overall torque $M_{tot}$ may be considered zero if comprised in a tolerance range which may depend, for example, on process variability during the manufacturing of the MEMS accelerometer 10, which might cause variations with respect to the design value.

In detail, considering a generic point Pi of the cap 70, the torque $M_i$ exerted by the cap 70 on the sensing mass 12 is given by:

$$M_i = br_i \cdot F_i \, ,$$

where bri is the arm of the point Pi with respect to the rotation axis R and $F_i$ the electrostatic force exerted by the cap 70 on the sensing mass 12.

For each region of the cap 70, the electrostatic force $F_i$ is a function of the facing area on and of the distance along the third axis Z from the sensing mass 12.

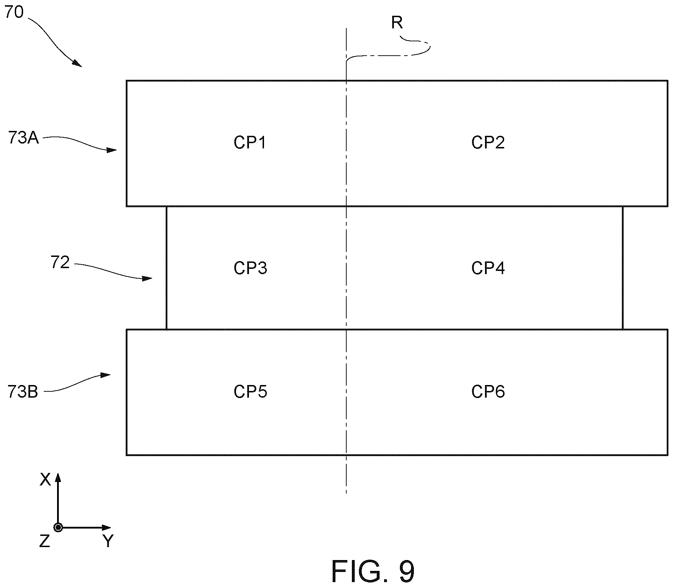

Figure 9 shows, schematically from above, the regions of the cap 70 facing the sensing mass 12.

The protruding region 73A may be divided into two portions CP1, CP2 arranged on two opposite sides of the rotation axis R along the second axis Y. The protruding region 73B may be divided into two portions CP5, CP6 arranged on two opposite sides of the rotation axis R along the second axis Y. The upper region 72 may be divided into two portions CP3, CP4 arranged on two opposite sides of the rotation axis R.

It may be verified that the overall torque $M_{tot}$ may be expressed as:

$$M_{tot} = \sum_i M_i = \sum_i br_i \cdot F_i \, ,$$

where for each portion Cpi with i=CP1,...,CP6, the arm $br_i$ may be approximated as the distance of the barycenter of the portion CPi from the rotation axis R along the second axis Y, and $F_i$ is the electrostatic force exerted by the portion CPi on the sensing mass 12.

In detail, $F_i = \frac{1}{2} \cdot \frac{\epsilon 0 \, A_i}{g_i^2} V^2$, where $A_i$ is the facing area of the portion CPi on the sensing mass 12 and gi the distance of the portion CPi from the sensing mass 12 along the third axis Z.

By suitably sizing the regions of the cap 70 facing the sensing mass 70, $M_{tot}=0$ may therefore be obtained, from which $\sum_i \frac{br_i \, A_i}{g^2 \, i} = 0$. The expression $\sum_i \frac{br_i \, A_i}{g^2 \, i} = 0$ may be used as a Figure of Merit (FOM) of the MEMS accelerometer 10.

The Applicant has verified that the overall torque $M_{tot}$ may be considered zero if the absolute value of said figure of merit is comprised between 0 and 1 (boundaries included or excluded).

For example, the MEMS accelerometer 10 may be designed in such a way that said figure of merit is comprised between 0 and 1. Or, even if the design value of said figure of merit is equal to 0, the figure of merit of the final MEMS accelerometer 10 may be different from zero due to variability during the manufacturing process.

In use, a potential difference even up to 1.5 V may establish between the cap 70 and the sensing mass 12.

For example, the potential difference may be caused by external electrostatic/electromagnetic disturbances. The potential difference may establish, in use, if the cap 70 is floating from an electrical point of view; for example, if the cap 70 is bonded to the substrate 11 through an insulating material.

However, the fact that the cap 70 is sized so as to cancel the overall torque $M_{tot}$ exerted on the sensing mass 12 causes the potential difference not to cause a spurious rotation component of the sensing mass 12 around the rotation axis R. As a result, the cap 70 contributes to increasing the sensing accuracy of the MEMS accelerometer 10.

In other words, the cap 70 may contribute to further optimize the performance and reliability of the MEMS accelerometer 10.

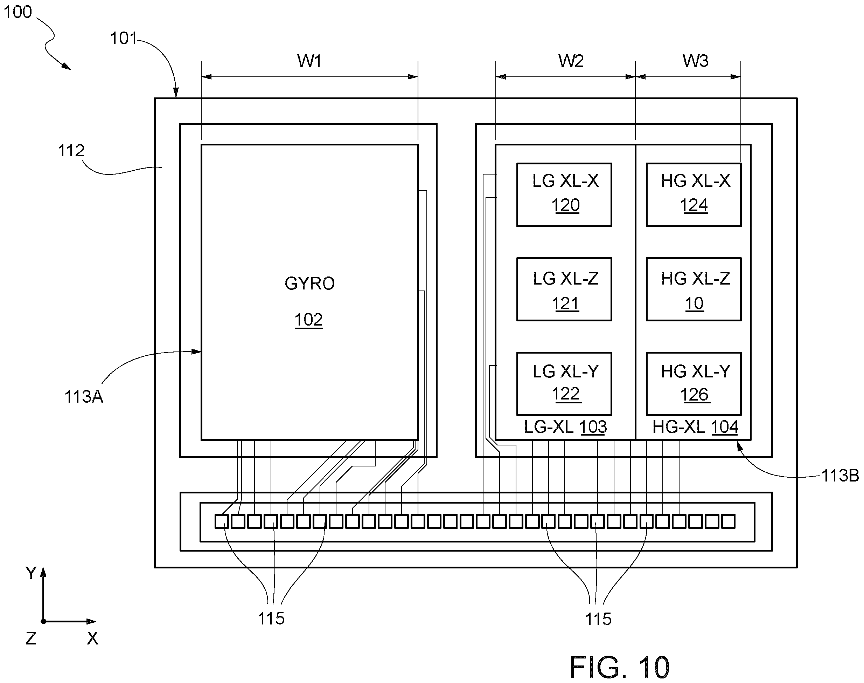

The MEMS accelerometer 10 may be integrated into an inertial device 100, shown in Figures 9 and 10 in the Cartesian reference system XYZ, comprising a plurality of MEMS inertial sensors integrated into a same die 101.

In detail, the inertial device 100 comprises a triaxial gyroscope (GYRO 102), a first triaxial accelerometer 103 indicated in the Figure by LG-XL, and a second triaxial accelerometer 104 indicated in the Figure by HG-XL.

The gyroscope 102 has a known structure, for example of the type described in the Italian patent application 102021000020504, corresponding to the US patent application US 4,124,827 and is arranged in a first half of the die 101.

The first triaxial accelerometer 103 is a low-g accelerometer, for example having a full-scale range lower than 100g, and comprises two in-plane monoaxial accelerometers 120, 122 for sensing in-plane accelerations parallel to the first and the second axes X, Y, and an out-of-plane monoaxial accelerometer 121 for sensing out-of-plane accelerations parallel to the third axis Z.

For example, the out-of-plane monoaxial accelerometer 121 may have the same structure as the MEMS accelerometer 10, or a different structure, depending on the specific application.

The second triaxial accelerometer 104 is a high-g accelerometer and comprises two in-plane monoaxial accelerometers 124, 126 for sensing in-plane accelerations parallel to the first and the second axes X, Y, and the out-of-plane monoaxial accelerometer 10 previously described for sensing out-of-plane accelerations parallel to the third axis Z.

The low-g 120, 122 and high-g 124, 126 in-plane accelerometers may have a structure similar to each other and be suitably sized so as to have different full-scales, or may have different structures, depending on the specification application.

The inertial sensors 102-104 are integrated into the die 101 in adjacent positions, as described below, and have main dimensions parallel to the plane XY.

The first triaxial accelerometer 103 and the second triaxial accelerometer 104 are arranged in a second half of the die 101, having an area slightly larger than the first half.

In detail, the gyroscope 102, the first triaxial accelerometer 103 and the second triaxial accelerometer 104 all have a rectangular area, are arranged side by side in the direction of the first axis X and have approximately a same height measured along a direction parallel to the second axis Y and a respective width, indicated by W1, W2, W3, respectively, measured in a direction parallel to the first axis X.

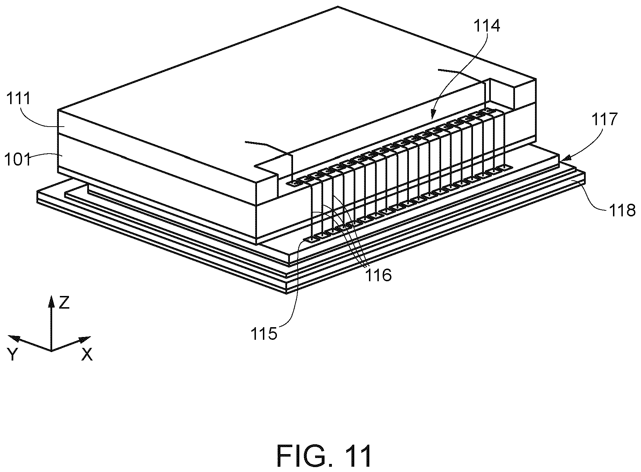

The die 101 is fixed to a cap 111, visible in Figure 11, through adhesive regions 112, shown in Figure 10.

The cap 111 may form the cap 70 described in reference to Figures 7 and 8. In other words, the cap 111 may have, at the out-of-plane accelerometer 10, the shape described in reference to the cap 70 of Figures 7 and 8.

Furthermore, the cap 111 may be sized, at the out-of-plane accelerometer 121, in a manner similar to what has been described for the cap 70, so as to prevent possible sensing errors of the out-of-plane accelerometer 121.

The cap 111 may be shaped so as to define two separate chambers, indicated schematically by 113A and 113B in Figure 10 and intended to accommodate the gyroscope 102 and, respectively, the triaxial accelerometers 103, 104. Furthermore, the cap 111 here has a recess 114 (Figure 11) to expose contact pads 115 formed on the die 101, in proximity to one of its sides.

As shown in Figure 11, wires 116 connect the contact pads 115 to a die 117 wherein a control circuit (ASIC) of the inertial device 100 may be formed. The die 117 is further coupled to a surface mounting support 118, for example of LGA (Land Grid Array) type.

The dice 101, 117, the cap 111 and the support 118 together may be packaged in a known manner, not shown, so as to form a packaged device having standard dimensions, for example 3.0 x 2.5 x 0.86 mm$^3$.

Finally, it is clear that modifications and variations may be made to the MEMS accelerometer described and illustrated herein without thereby departing from the scope of the present invention, as defined in the attached claims.

The sensing mass 12 may generally be provided with a series of through holes 140 that occupy its entire area, as shown exemplarily in Figure 7 and, by way of example only in the top right corner, in Figures 1 and 5.

For example, the MEMS accelerometer 10 may have a structure other than the teeter-totter one, wherein the sensing mass 12 is coupled to the substrate 11 so as to undergo an out-of-plane movement other than a rotation (for example a translation) in response to an acceleration of the MEMS accelerometer along the out-of-plane direction (Z).

The MEMS accelerometer 10 may have a teeter-totter structure, but a shape other than what has been shown and described.

For example, the MEMS accelerometer 10 may have a different number of springs and central anchoring regions. For example, the springs and the central anchoring region may have a shape and arrangement other than what has been shown and described.

For example, the frame 50 may extend only in part around the sensing mass 12.

For example, the MEMS accelerometer may have a different number of (additional and/or modified) damping structures, depending on the specific application.

For example, for each modified damping structure 25A-25D, only the fixed fingers 31A-31E or only the movable fingers 30A-30D may have variable length.

For example, arrangement, number and shape of the in-plane and/or out-of-plane stopper regions may be different from what has been shown.

In view of the above disclosure, in particular with reference to what described for Figures 4 and 5, a MEMS accelerometer may be summarized as comprising:

a substrate;
a sensing mass suspended at a distance from the substrate along an out-of-plane direction (e.g., axis Z), the sensing mass being coupled to the substrate so as to undergo an out-of-plane movement with respect to the substrate, in response to an acceleration along the out-of-plane direction; and
a frame fixed to the substrate and which extends, at least in part, around the sensing mass,
wherein the sensing mass has an external wall facing the frame and a recess in the external wall, the frame comprising a bumper region configured to form an in-plane stopper region of the sensing mass which extends towards the sensing mass inside the recess.

Moreover, in view of the above disclosure, in particular with reference to what described for Figures 7-9, a MEMS accelerometer may be summarized as comprising:

a substrate;
a sensing mass suspended at a distance from the substrate along an out-of-plane direction (e.g., axis Z), the sensing mass being coupled to the substrate so as to undergo an out-of-plane movement with respect to the substrate, in response to an acceleration along the out-of-plane direction; and
a cap fixed to the substrate and having a first region extending over the sensing mass at a distance from the sensing mass along the out-of-plane direction, the first region being sized so that, in presence of a voltage difference between the first region of the cap and the sensing mass, the first region of the cap exerts a zero overall torque on the sensing mass.

Finally, the different embodiments described above may be combined to provide further solutions.

## Claims

1. A MEMS accelerometer (10) comprising:

   a substrate (11);
   a sensing mass (12) suspended at a distance from the substrate along an out-of-plane direction (Z), the sensing mass being coupled to the substrate so as to undergo an out-of-plane movement with respect to the substrate, in response to an acceleration along the out-of-plane direction; and
   a damping structure (25A-25D) configured to damp an in-plane movement of the sensing mass with respect to the substrate, comprising a plurality of movable fingers (30A-30D) integral with the sensing mass (12) and a plurality of fixed fingers (31A-31E) integral with the substrate (11) and interdigitated with the movable fingers,
   wherein the movable fingers and/or the fixed fingers have, along a first in-plane direction (X) transversal to the out-of-plane direction (Z), a variable length.

2. The MEMS accelerometer according to the preceding claim, wherein the out-of-plane movement is a rotation of the sensing mass around a rotation axis (R) that is non-barycentric and transversal to the out-of-plane direction (Z) .

3. The MEMS accelerometer according to claim 1 or 2, wherein the movable fingers (30A-30D) are spaced apart one from the other along a second in-plane direction (Y) transversal to the first in-plane direction (X) and to the out-of-plane direction (Z), and the fixed fingers (31A-31E) are spaced apart one from the other along the second in-plane direction (Y).

4. The MEMS accelerometer according to the preceding claim, wherein the length of the movable fingers and/or the fixed fingers is measured along the first in-plane direction (X),
   wherein the length of the movable fingers varies between different movable fingers (30A, 30B) and/or the length of the fixed fingers varies between different fixed fingers (31A, 31B).

5. The MEMS accelerometer according to claim 3 or 4, when dependent on claim 2, wherein the movable fingers comprise a first movable finger (30A) arranged at a first distance, along the second in-plane direction (Y), from the rotation axis (R) and a second movable finger (30B) arranged at a second distance, along the second in-plane direction (Y), from the rotation axis (R), the second distance being greater than the first distance and the length of the second movable finger along the first in-plane direction (X) being lower than the length of the first movable finger along the first in-plane direction (X), and/or wherein the fixed fingers comprise a first fixed finger (31A) arranged at a third distance, along the second in-plane direction (Y), from the rotation axis (R) and a second fixed finger (31B) arranged at a fourth distance, along the second in-plane direction (Y), from the rotation axis (R), the fourth distance being greater than the third distance and the length of the second fixed finger along the first in-plane direction (X) being lower than the length of the first fixed finger along the first in-plane direction (X).

6. The MEMS accelerometer according to any of claims 3-5, wherein the fixed fingers (31A-31E) and the movable fingers (30A-30D) face each other along the second in-plane direction (Y), wherein the length of the fixed fingers and/or the movable fingers along the first in-plane direction (X) decreases parallel to the second in-plane direction (Y).

7. The MEMS accelerometer according to the preceding claim, wherein the length along the first in-plane direction (X) of the fixed fingers and/or the movable fingers decreases, parallel to the second in-plane direction towards an external wall (13A) of the sensing mass.

8. The MEMS accelerometer according to any of the preceding claims, wherein the length along the first in-plane direction (X) of the fixed fingers and/or the movable fingers has a linear trend along a second in-plane direction (Y) transversal to the first in-plane direction (X) and to the out-of-plane direction (Z).

9. The MEMS accelerometer according to any of the preceding claims, further comprising:

   a first through cavity (20) extending through the sensing mass (12), the sensing mass having an internal wall (20A) facing the first through cavity;
   an anchoring region (14) of the sensing mass (12), fixed to the substrate (11), arranged in the first through cavity and facing the internal wall (20A) of the sensing mass parallel to the first in-plane direction (X); and
   a second through cavity (27A-27D) extending through the sensing mass (12),
   the fixed fingers (31A-31E) and the movable fingers (30A-30D) of the damping structure extending in the second through cavity (27A-27D), the fixed fingers extending towards the first through cavity.

10. The MEMS accelerometer according to the preceding claim, wherein the fixed fingers (31A-31E) and/or the movable fingers (30A-30D) have a minimum length, along the first in-plane direction (X), at a curvature portion (33) of the internal wall (20A) of the sensing mass (12).

11. The MEMS accelerometer according to any of the preceding claims, comprising a frame (50) fixed to the substrate (11) and which extends, at least in part, around the sensing mass (12), wherein the sensing mass has an external wall (13A) facing the frame and a recess (55) in the external wall (13A), the frame comprising a bumper region (53) configured to form an in-plane stopper region of the sensing mass and extending towards the sensing mass inside the recess.

12. The MEMS accelerometer according to the preceding claim when dependent on claim 2, wherein the external wall (13A) is a first perimeter portion of the sensing mass which extends at a first distance ($D_1$) from the rotation axis (R) along a second in-plane direction (Y) transversal to the first in-plane direction (X) and to the out-of-plane direction (Z), the sensing mass having a second perimeter portion (13B) which extends at a second distance ($D_2$) from the rotation axis along the second in-plane direction, the first distance being longer than the second distance.

13. The MEMS accelerometer according to any of the preceding claims, further comprising a cap (70) fixed to the substrate (11) and having a first region (70, 73A, 73B) extending over the sensing mass (12) at a distance from the sensing mass along the out-of-plane direction (Z), the first region being sized so that, in presence of a voltage difference between the first cap region and the sensing mass, the first cap region exerts a zero overall torque on the sensing mass (12).

14. The MEMS accelerometer according to the preceding claim, wherein the first cap region comprises at least one first portion (72) at a first distance ($g_c$) from the sensing mass along the out-of-plane direction (Z) and at least one protruding portion (73A, 73B) at a second distance ($g_c$) from the sensing mass along the out-of-plane direction (Z), the second distance being shorter than the first distance.

15. The MEMS accelerometer according to any of the preceding claims, for sensing high out-of-plane accelerations.

16. The MEMS accelerometer according to any of the preceding claims, further comprising at least one sensing electrode (18A, 18B) integral with the substrate (11) and extending, at rest, at a distance from the sensing mass along the out-of-plane direction, the at least one sensing electrode being capacitively coupled to the sensing mass.

FIG. 1

EP 4 582 815 A1

FIG. 2

FIG. 6A

FIG. 6B

FIG. 3A

FIG. 3B

EP 4 582 815 A1

FIG. 4

FIG. 5

EP 4 582 815 A1

FIG. 8

FIG. 7

FIG. 9

FIG. 10

FIG. 11

EP 4 582 815 A1

# EUROPEAN SEARCH REPORT

**Application Number**

EP 24 22 3175

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/314466 A1 (NAGATA KAZUYUKI [JP]) 5 October 2023 (2023-10-05) | 1-3,5-8, 15,16 | INV. G01P15/125 |
| Y | * paragraphs [0029], [0035], [0041] - [0045], [0048]; figures 1-13 * | 9-14 | ADD. G01P15/08 |
| | ----- | | |
| X | US 2023/266359 A1 (KOMIZO KOICHIRO [JP]) 24 August 2023 (2023-08-24) * paragraphs [0025], [0026], [0028] - [0031], [0054]; figure 8 * | 1-7 | |
| | ----- | | |
| Y | US 2012/031185 A1 (CLASSEN JOHANNES [DE] ET AL) 9 February 2012 (2012-02-09) * paragraphs [0031], [0033]; figures 1-10 * | 9,10 | |
| | ----- | | |
| Y | US 2014/174183 A1 (COMI CLAUDIA [IT] ET AL) 26 June 2014 (2014-06-26) * paragraph [0071]; figures 1-6 * | 11,12 | |
| | ----- | | |
| Y | US 2021/285981 A1 (RIZZINI FRANCESCO [IT] ET AL) 16 September 2021 (2021-09-16) * paragraphs [0073] - [0076]; figure 6 * | 11,12 | TECHNICAL FIELDS SEARCHED (IPC) |
| | ----- | | G01P |
| Y | US 2011/226059 A1 (WELLNER PATRICK [DE] ET AL) 22 September 2011 (2011-09-22) * paragraphs [0005], [0007], [0009], [0010], [0012], [0022]; figures 1-6 * | 13,14 | |
| | ----- | | |

The present search report has been drawn up for all claims

| Place of search | Date of completion of the search | Examiner |
|---|---|---|
| Munich | 19 May 2025 | Schwarz, Cornelia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 3175

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2025

| Patent document cited in search report | Publication date | Patent family member(s) | | Publication date |
|---|---|---|---|---|
| US 2023314466 A1 | 05-10-2023 | CN | 116893282 A | 17-10-2023 |
| | | JP | 2023152416 A | 17-10-2023 |
| | | US | 2023314466 A1 | 05-10-2023 |
| US 2023266359 A1 | 24-08-2023 | CN | 116626337 A | 22-08-2023 |
| | | JP | 2023121380 A | 31-08-2023 |
| | | US | 2023266359 A1 | 24-08-2023 |
| US 2012031185 A1 | 09-02-2012 | DE | 102010039069 A1 | 09-02-2012 |
| | | US | 2012031185 A1 | 09-02-2012 |
| US 2014174183 A1 | 26-06-2014 | CN | 103827673 A | 28-05-2014 |
| | | DE | 112012003562 T5 | 15-05-2014 |
| | | US | 2014174183 A1 | 26-06-2014 |
| | | WO | 2013030798 A1 | 07-03-2013 |
| US 2021285981 A1 | 16-09-2021 | CN | 113406355 A | 17-09-2021 |
| | | CN | 215953660 U | 04-03-2022 |
| | | EP | 3882640 A1 | 22-09-2021 |
| | | IT | 202000005563 A1 | 16-09-2021 |
| | | US | 2021285981 A1 | 16-09-2021 |
| | | US | 2023083632 A1 | 16-03-2023 |
| US 2011226059 A1 | 22-09-2011 | DE | 102008042366 A1 | 01-04-2010 |
| | | EP | 2331974 A1 | 15-06-2011 |
| | | US | 2011226059 A1 | 22-09-2011 |
| | | WO | 2010034554 A1 | 01-04-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2023314466 A1
- IT 102021000020504

- US 4124827 A